Europäisches Patentamt

European Patent Office

Office européen des brevets

(11) Publication number: **0 632 369 A1**

# EUROPEAN PATENT APPLICATION

(21) Application number: **93201892.2**

(51) Int. Cl.6: **G06F 7/544**

(22) Date of filing: **29.06.93**

(43) Date of publication of application:
**04.01.95 Bulletin 95/01**

(84) Designated Contracting States:
**AT BE CH DE DK ES FR GB GR IE IT LI LU MC NL PT SE**

(71) Applicant: **Stichting voor de Technische Wetenschappen**
**Van Vollenhovenlaan 661**
**P.O. Box 3021**
**NL-3502 GA Utrecht (NL)**

(72) Inventor: **Hekstra, Gerben Johan**

**Bikolaan 7**
**NL-2622 EH Delft (NL)**
Inventor: **Deprettere, Edmond Ferdinand Andries**
**Nieboerweg 232**
**NL-2566 GD Den Haag (NL)**

(74) Representative: **de Bruijn, Leendert C. et al**
**Nederlandsch Octrooibureau**
**Scheveningseweg 82**
**P.O. Box 29720**
**NL-2502 LS Den Haag (NL)**

(54) CORDIC algorithms and architectures.

(57) A CORDIC arrangement to rotate an input vector $(x_{in}, y_{in})$ over an angle $\alpha$ to an output vector $(x_{out}, y_{out})$, the coordinates being represented by floating-point numbers with respective mantissas $(m_x, m_y)$ and respective angle exponents $(e_x, e_y)$ comprising:
- a pre-rotation unit (1) receiving the input vector $(x_{in}, y_{in})$ to rotate the input vector $(x_{in}, y_{in})$ over an angle $\beta_{pre}$;
- a core (2) connected to the pre-rotation unit 1 and carrying out a vectoring operation or a rotation operation in dependence on a mode signal (mode);
- a post-rotation unit (4) connected to the core (2) to carry out a post-rotation in dependence on the mode signal (mode);
- a rotation handler (3) receiving the mode signal (mode) and connected to both the pre-rotation unit (1) and to the post-rotation unit (3) in order to control their operation.

fig-2

EP 0 632 369 A1

The present invention relates to CORDIC algorithms and architectures. The CORDIC (COordinate Rotation DIgital Computer) algorithm was presented by Volder, "The CORDIC trigonometric computing technique", IRE Transactions on electronic computers, pages 330-334, September 1959, as an elegant and cost-effective method to perform rotations on vectors in the 2-D plane. Walther, "A unified algorithm for elementary functions", Proceedings of the AFIPS Spring Joint Computer Conference, pages 379-385, 1971, extended the algorithm to rotations in circular, linear and hyperbolic coordinate systems. Since then, many implementations of the CORDIC have been made, both for fixed-point and floating-point with respect to the input.

CORDIC computing techniques are widely used in e.g. navigation where course angles have to be corrected and distance-to-destination relationships in great circle steering have to be solved. However, the magnitude and phase of a complex number may also be approximated by a CORDIC, EP-A-0.365.226. Also, a CORDIC may be an element in a filter arrangement to detect phase differences, EP-A-0.481.543. A digital receiver comprising a CORDIC is described in EP-A-0.486.095. Generally spoken, a CORDIC may be used in any technical field in which an input vector has to be rotated to an output vector.

The main drawback in the computations with floating-point data with the classic CORDIC algorithm lies with the inherent fixed-point resolution of the angle. The accuracy, especially when calculating angles close to or smaller than the angle resolution, becomes unacceptable. Therefore, in applications using a CORDIC there is a need to enhance the accuracy of the output data of the CORDIC in order not to loose any precision by the use of CORDIC's.

The object of the present invention is to provide CORDIC architectures and algorithms that overcome the problems of the prior art.

In accordance with the present invention the object is obtained by a CORDIC arrangement to rotate an input vector $(x_{in}, y_{in})$ over an angle $\alpha$ to an output vector $(x_{out}, y_{out})$, characterized in that $x_{in}$, $y_{in}$, $x_{out}$, $y_{out}$ are represented by floating-point numbers with respective mantissas $(m_x, m_y)$ and respective angle exponents $(e_x, e_y)$ and the CORDIC arrangement comprises:

(a) a pre-rotation unit receiving the input vector $(x_{in}, y_{in})$ to rotate the input vector $(x_{in}, y_{in})$ over an angle $\beta_{pre}$ to give a vector $(x_{pre}, y_{pre})$;

(b) a core receiving the vector $(x_{pre}, y_{pre})$ from the pre-rotation unit to rotate the vector $(x_{pre}, y_{pre})$ over an angle $\gamma$ to give a vector $(x_{core}, y_{core})$, where the angle $\gamma$, depending on a signal mode supplied by an operator, is either supplied by the operator as $\gamma_{in}$ or computed and output as $\gamma_{out}$;

(c) a rotation handler receiving the angle $\beta_{pre}$ from the prerotation unit and the signal mode supplied by an operator, and a possible angle $\beta_{in}$ supplied by the operator to compute angles $\beta_{post}$, $\beta_{out}$ in dependence thereon;

(d) a post-rotation unit receiving the vector $(x_{core}, y_{core})$ from the core and receiving the angle $\beta_{post}$ from the rotation handler to rotate the vector $(x_{core}, y_{core})$ over the angle $\beta_{post}$ to give the output vector $(x_{out}, y_{out})$;

wherein

(a) the floating-point angle $\alpha$ is represented by a tuple $(\beta, \gamma)$, $\beta$ being the sum of $\beta_{pre}$ and $\beta_{post}$, and $\gamma$ being represented by a tuple $(\xi, \zeta)$, of which $\xi$ is an angle exponent and $\zeta$ is an angle mantissa;

(b) $\alpha$ equals the sum of $\beta$ and $\gamma$.

By the application of these measures an accuracy in the output vector may be obtained to such precision that the error introduced by the CORDIC computation is smaller than the error which can be accounted to the (in)accuracy of the input data.

In a first preferred embodiment of the CORDIC arrangement defined above it is characterized in that the core comprises:

(a) an exponent handler receiving the exponents $(e_{x,pre}, e_{y,pre})$ of the vector $(x_{pre}, y_{pre})$ and computing a CORDIC table selector $\Xi$, and alignment factors $a_{y,pre}$, $a_{x,core}$ and $a_{y,core}$, exponents $(e_{x,core}, e_{y,core})$ of the vector $(x_{core}, y_{core})$ and, depending on the signal mode, either receiving from the operator an angle exponent $\xi_{in}$ or computing an angle exponent $\xi_{out}$;

(b) an instruction sequencer receiving the cordic table selector $\Xi$ from the exponent handler and producing a sequence of instructions I;

(c) an instruction execution unit receiving the mantissas $(m_{x,pre}, m_{y,pre})$ of the vector $(x_{pre}, y_{pre})$, receiving the alignement factors $a_{y,pre}$, $a_{x,core}$ and $a_{y,core}$ from the exponent handler and receiving the sequence of instructions I supplied by the instruction sequencer and, depending on the signal mode, either receiving an angle mantissa $\zeta_{in}$ supplied by the operator or computing an angle mantissa $\zeta_{out}$ producing mantissas $(m_{x,core}, m_{y,core})$ of the vector $(x_{core}, y_{core})$.

Such a CORDIC arrangement has a sequential implementation and therefore saves chip area.

2

A similar scheme for floating-point on-line computation of Givens rotations has been presented in M. Ercegovac and T. Lang, "On-line scheme for computing rotation factors", Journal of parallel and distributed Computing, 5:209-227, 1988. However, in this scheme no CORDIC arithmetic was used and the implementation shows up to be very complex.

In a second preferred embodiment the CORDIC arrangement is characterized in that the core comprises:

(a) an exponent handler receiving the exponents ($e_{x,pre}$, $e_{y,pre}$) of the vector ($x_{pre}$, $y_{pre}$) and computing a CORDIC table selector $\Xi$, alignment factors $a_{y,coarse}$, $a_{y,fine}$, $a_{y,fixed}$, $a_{y,fixed}$, exponents ($e_{x,coarse}$, $e_{y,coarse}$) of a vector ($x_{coarse}$, $y_{coarse}$) and, depending on the signal mode, either receiving from the operator an angle exponent $\xi_{in}$ or computing an angle exponent $\xi_{out}$;

(b) a coarse core receiving the mantissas ($m_{x,pre}$, $m_{y,pre}$) of the vector ($x_{pre}$, $y_{pre}$) and receiving the alignment factor $a_{y,coarse}$ from the exponent handler and, depending on the signal mode, receiving a coarse angle mantissa $\zeta_{in,coarse}$ supplied by the operator, or producing $\zeta_{out,coarse}$, to compute mantissas ($m_{x,coarse}$, $m_{y,coarse}$) of the vector ($x_{coarse}$, $y_{coarse}$);

(c) a fine core receiving the mantissas ($m_{x,coarse}$, $m_{y,coarse}$) from the coarse core and receiving the alignment factors $a_{y,fine}$, $a_{y,fixed}$ and $a_{y,fixed}$ from the exponent handler and, depending upon the signal mode, receiving a fine angle mantissa $\zeta_{in,fine}$ supplied by the operator, or producing $\zeta_{out,fine}$, to compute the mantissas ($m_{x,core}$, $m_{y,core}$) of the vector ($x_{core}$, $y_{core}$);

wherein the angle mantissa $\zeta$ is represented by a tuple ($\zeta_{coarse}$, $\zeta_{fine}$) and, depending on the signal mode, is either input by the operator as $\zeta_{in}$ or computed and output as $\zeta_{out}$.

Such a CORDIC arrangement has an efficient parallel, pipelined implementation.

The invention further relates to a method defined in claims 4, 5, 6.

First, a short summary of the original CORDIC algorithm will be given.

The CORDIC algorithm knows two modes of operation, namely vectoring and rotation which are equivalent to the so-called backward and forward Givens rotations.

In the vectoring mode, the vector $(x,y)_{in}$ is rotated to

$$(x,y)_{out} = ([x^2_{in} + y^2_{in}]^{\frac{1}{2}}, 0)$$

and thereby computing the angle of inclination $\alpha_{out}$.

In the rotation mode, the vector $(x,y)_{in}$ is rotated over a given angle $\alpha_{in}$ to $(x,y)_{out}$.

The basic idea behind the CORDIC algorithm is that a rotation is decomposed into a sequence of n so-called unnormalized micro-rotations over the base angles $\alpha_i$, with $i \in \{0, ..., n-1\}$ and $0 < \alpha_i \leq \pi/2$. These base angles are chosen in such a way that the micro-rotations are easy to execute (implement) in hardware.

The general recursion for the micro-rotations is given by:

$$x_{i+1} = x_i - (\sigma_i \tan \alpha_i)y_i$$
$$y_{i+1} = +(\sigma_i \tan \alpha_i)x_i + y_i \qquad (1)$$

with the input and output to the recursion:

$$x_0 = K^{-1} \cdot x_{in} \qquad x_{out} = x_n$$

$$\text{and} \qquad\qquad\qquad (2)$$

$$y_0 = K^{-1} \cdot y_{in} \qquad y_{out} = y_n$$

The use of unnormalized micro-rotations in the recursion (1) causes that the vector is lengthened or scaled by a factor $1/\cos\alpha_i$ with every step. Hence the need for a division by K in equation (2), where K is the accumulative scaling factor given by:

$$K = \prod_{i=0}^{n-1} \frac{1}{\cos\alpha_i} \qquad (3)$$

The $\sigma_i$ in the recursion (1) indicates the direction of the micro-rotation. These "sigma-bits" $\sigma_i$ can be either -1 or +1, signifying clockwise resp. counterclockwise rotations.

The relationship between the angle of rotation $\alpha$ and the sequence of sigma bits $\{\sigma_i\}$ is given by the summation:

$$\alpha = + \sum_{i=0}^{n-1} \sigma_i \alpha_i \qquad (4)$$

In order to converge for any angle within a given domain of convergence, the sequence of base angles must form a basis and hence satisfy the conditions:

$$\alpha_i \leq \sum_{k>i}^{n-1} \alpha_k + \alpha_{min}; \quad \alpha_{min} = \alpha_{n-1} \qquad (5)$$

$$\alpha_i \geq \alpha_{i+1} \qquad (6)$$

We will refer to the sequence of base angles $\{\alpha_i\}$ as the angular basis. The domain of convergence r is given by the sum of the base angles:

$$r = + \sum_{i=0}^{n-1} \alpha_i + \alpha_{min} \qquad (7)$$

For any angle $\alpha$ within the domain of convergence, with $|\alpha| \leq r$, the CORDIC algorithm will converge with the resolution determined by the smallest base angle.

In order to keep the implementation of the micro-rotations simple, we introduce:

$$a_i = \tan \alpha_i \qquad (8)$$

and require that the multiplication by $a_i$ is of low complexity when implemented in hardware. We opt for the approach presented by Bu et al.[1], where

$$a_i = 2^{+S_i} + \eta_i \cdot 2^{+S'_i} \qquad \eta_i \in \{-1, 0, 1\} \qquad (9)$$

with the shift factors $S_i$ and $S'_i$ being integer numbers. Using this scheme, the micro-rotation in recursion (1) is either a pair on one ($\eta_i = 0$) or two ($\eta_i \neq 0$) shift- and add operations.

A definition of floating-point numbers is given. A floating-point number x is represented by a tuple $(e_x, m_x)$ with:

exponent An $N_e$-bit exponent $e_x$. The number of bits $N_e$ determine the dynamic range of the representation.

mantissa An $N_m$-bit, signed, mantissa $m_x$. The number of bits $N_m$, not including the sign bit, determine the precision of the representation. Assuming correct rounding, the mantissa $m_x$ has an inherent accuracy of $\pm \frac{1}{2}$ lsb, where lsb $= 2^{-N_m+1}$ is the weight for the least significant bit.

The corresponding value of x is given by

$$x = m_x 2^{e_x} \qquad (10)$$

4

For the sake of discussion, we will assume that the input of the floating-point CORDIC is normalized. This means that the mantissa lies within the range given by:

$$1.00...00_2 \leq m_x \leq 1.11...11_2$$
$$1 \leq m_x \leq 2 - \text{lsb} \quad (11)$$

The IEEE 754 Standard for Binary Floating-Point Arithmetic allows representations for denormalized numbers, zero, infinity and "Not a Number" (NaN). It has to be mentioned here that all of these too can be elegantly handled by the floating-point CORDIC implementation presented in the present patent application. To deal with this in detail, however, is beyond the scope of this patent application.

The invention will be further explained referring to the figures in which some preferred embodiments are shown, by way of example.

Figure 1 shows a part of the (x,y) floating-point domain;

Figure 2 shows a CORDIC-arrangement;

Figure 3 shows a sequential CORDIC-arrangement;

Figure 4 shows a parallel CORDIC-arrangement.

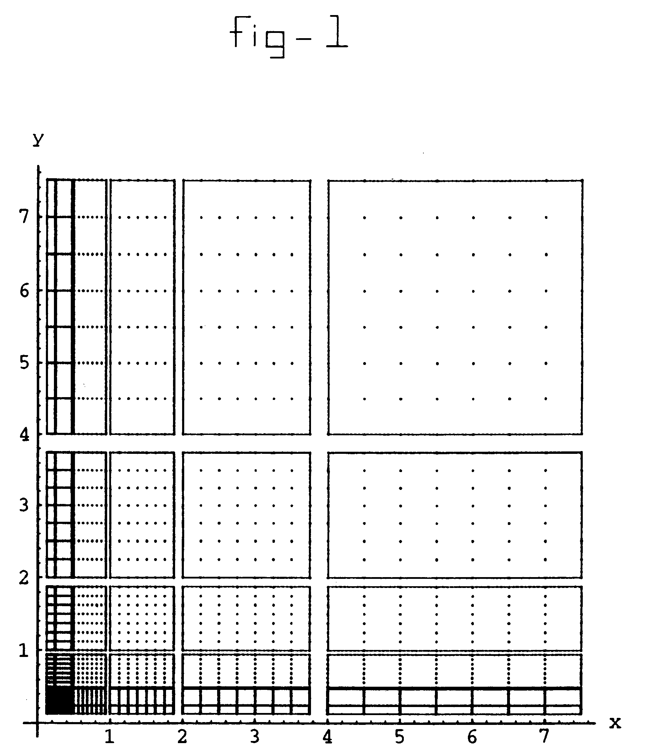

Before the working of the floating-point CORDIC is explained, first, the following observation is made: the floating-point CORDIC works on floating-point vectors (x,y). All the possible values for the vector (x,y) lie in the floating-point domain, as is visualized in figure 1. The boxed areas represent regions in the domain in which the x and y exponents are constant. The points within such a region represent all possible values for the floating-point numbers with normalized mantissa. In the example shown in figure 1, we have taken $N_m = 4$, giving $1,000_2 \leq m_x, m_y \leq 1,111_2$. The large box in the top-right corner of the figure represents the region with $e_x = 2$, $e_y = 2$. The figure only shows a part of the domain and only the first quadrant, for positive vectors. It should be extended by mirroring in the x- and y-axes.

Now, there will be explained how, in accordance with the present invention, a floating-point CORDIC algorithm that can rotate a floating-point vector (x,y) over a floating-point angle $\alpha$ is derived. First, the floating-point CORDIC will be defined and a representation of the angle $\alpha$ in an internal floating-point format will be given.

In the floating-point CORDIC, a floating-point vector $(x,y)_{in}$ is rotated to $(x,y)_{out}$ over the floating-point angle of rotation $\alpha$. How this angle $\alpha$ is derived depends on whether the mode of operation is vectoring or rotation.

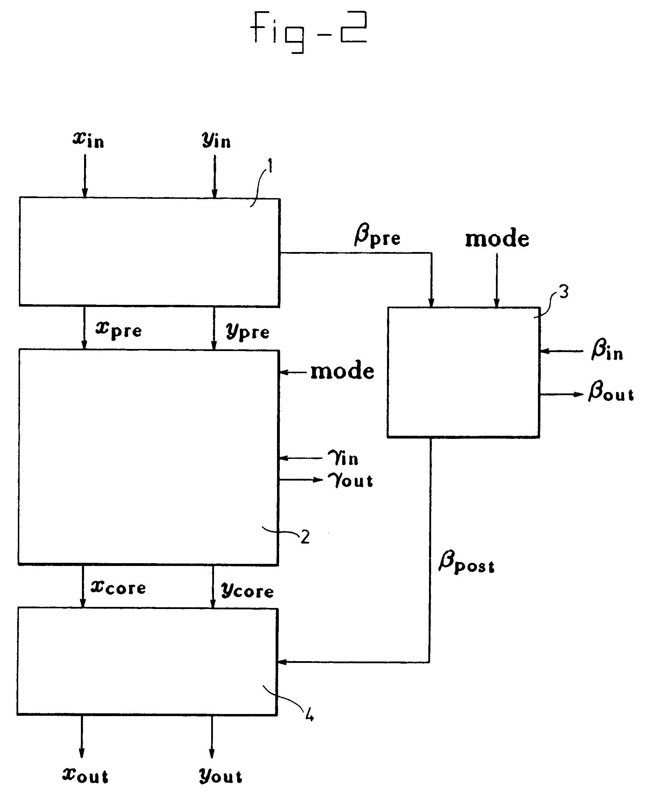

Figure 2 shows a general arrangement of a CORDIC capable of computing output data $(x,y)_{out}$ to such precision that the error introduced by the CORDIC computation is smaller than the error that can be accounted to the (in)accuracy of the input data. The arrangement of figure 2 comprises four elements: a pre-rotation unit 1, a core 2, a post-rotation unit 4, and a rotation handler 3.

The pre-rotation unit 1 has two inputs $x_{in}$, $y_{in}$ and three outputs $x_{pre}$, $y_{pre}$, $\beta_{pre}$. The inputs $x_{in}$, $y_{in}$ are floating-point numbers, as are the outputs $x_{pre}$, $y_{pre}$. $\beta_{pre}$ is represented by a tuple $(\sigma_{\pi/2,pre}, \sigma_{\pi,pre})$ with $\sigma_{\pi/2,pre}$, $\sigma_{\pi,pre} \in \{0,1\}$ and $\beta_{pre} = \sigma_{\pi/2,pre} \cdot \pi/2 + \sigma_{\pi,pre} \cdot \pi$. The function of the pre-rotation unit 1, in combination with the post-rotation unit 4 is to solve the problem of accurately representing angles (of vectors) close to the x- and y-axes. The operation will be explained hereinafter.

The core 2 has four inputs $x_{pre}$, $y_{pre}$, $\gamma_{in}$ and mode and three outputs $x_{core}$, $y_{core}$ and $\gamma_{out}$. The inputs are connected to the outputs $x_{pre}$, $y_{pre}$, respectively of the pre-rotation unit 1. The input signal mode denotes whether the mode of operation is vectoring or rotation. The purpose of the core 2 is to compute the output signals $x_{core}$, $y_{core}$ from the input signals $x_{pre}$, $y_{pre}$ in accordance with the desired vectoring or rotation mode.

The post-rotation unit 4 has three inputs $x_{core}$, $y_{core}$, $\beta_{post}$ and two outputs $x_{out}$, $y_{out}$. The post-rotation unit 4 performs a rotation on the input signals $x_{core}$, $y_{core}$ present on its inputs, whenever there has been pre-rotations by the pre-rotation unit 1. The post-rotation unit 4 is controlled by the rotation handler 3 through the input $\beta_{post}$.

The rotation handler 3 has three inputs $\beta_{pre}$, mode, $\beta_{in}$ and two outputs $\beta_{out}$, $\beta_{post}$. The inputs $\beta_{pre}$ and mode are defined above. The input $\beta_{in}$ receives a tuple $(\sigma_{\pi/2,in}, \sigma_{\pi,in})$. The output $\beta_{out}$ is represented by a tuple $(\sigma_{\pi/2,out}, \sigma_{\pi,out})$ and $\beta_{post}$ by a tuple $(\sigma_{\pi/2,post}, \sigma_{\pi,post})$.

The rotation handler 3 computes the angles $\beta_{post}$, $\beta_{out}$ from the input $\beta_{pre}$, $\beta_{in}$ depending on the mode. If the mode is vectoring, then the angle output $\beta_{out}$ is the same as the angle produced by the pre-rotations $\beta_{pre}$; no post rotation is necessary. If the mode is rotation, then the angle that the input vector should be rotated over is given by $\beta_{in}$; since the input is already rotated over $\beta_{pre}$ by the pre-rotations, post-rotations must correct this by rotating over $\beta_{post} = \beta_{in} - \beta_{pre}$.

First, an algorithm allowed to be implemented in the architecture of figure 2 will be described. The floating-point CORDIC consists of three distinctive operations. They are:

1. A pre-rotation over the angle $\beta_{pre}$.
2. A core-rotation over the angle $\gamma$.
3. A post-rotation over the angle $\beta_{post}$.

In the first step (pre-rotation) the input data, $(x_{in}, y_{in})$, is rotated to the region of convergence using accuracy-preserving rotations over $+\pi/2$ and $+\pi$ radians. These rotations take effect in changing the signs and exchanging the exponents and mantissas between x and y and therefore do not affect the precision that is present in the data.

The rotation over $+\pi/2$ radians is performed if $|y_{in}| > |x_{in}|$, otherwise no rotation is performed. The result of this rotation is an intermediate vector $(x_{int}, y_{int})$.

$$
\begin{aligned}
&\textbf{if } |y_{in}| > |x_{in}| \textbf{ then} \\
&\qquad \sigma_{\pi/2, pre} = 1 \\
&\qquad x_{int} = -y_{in} \\
&\qquad y_{int} = x_{in} \\
&\textbf{else} \\
&\qquad \sigma_{\pi/2, pre} = 0 \\
&\qquad x_{int} = x_{in} \\
&\qquad y_{int} = y_{in} \\
&\textbf{end if}
\end{aligned}
\qquad (12)
$$

The rotation over $\pi$ radians is performed if the resulting $x_{int}$ is negative. The combination of these rotations brings the input data to the halfplane $x \geq 0$.

$$
\begin{aligned}
&\textbf{if } x_{int} < 0 \textbf{ then} \\
&\qquad \sigma_{\pi, pre} = 1 \\
&\qquad x_{pre} = -x_{int} \\
&\qquad y_{pre} = -y_{int} \\
&\textbf{else} \\
&\qquad \sigma_{\pi, pre} = 0 \\
&\qquad x_{pre} = x_{int} \\
&\qquad y_{pre} = y_{int} \\
&\textbf{end if}
\end{aligned}
\qquad (13)
$$

The following properties now hold for the resulting $(x_{pre}, y_{pre})$ data:

$$e_{x,pre} \geq e_{y,pre} \qquad (14)$$

$$x_{pre} \geq |y_{pre}| \geq 0 \qquad (15)$$

The pre-rotations serve two purposes. Firstly, they make it possible to accurately represent angles which are close to the x- and y-axes, rather than just angles close to the positive x-axis. Secondly, the formulas and the calculations in the core 2 can be greatly simplified due to the prior knowledge of condition (14).

The value of the angle $\beta_{pre}$ is given by

$$\beta_{pre} = \sigma_{\pi, pre} \cdot \pi + \sigma_{\pi/2, pre} \cdot \pi/2 \qquad (16)$$

with $\sigma_{\pi/2,\text{pre}}$, $\sigma_{\pi,\text{pre}} \in \{0, 1\}$.

Step 2 (core rotation) of the floating-point CORDIC algorithm requires the definition of an angle exponent.

Looking at the floating-point domain in figure 1 we see that when two regions have the same difference in exponents $e_x$-$e_y$ they share the same domain of convergence and accuracy in angles. This is due to the equivalence:

$$\tan^{-1}\left(\frac{m_y \cdot 2^{e_y}}{m_x \cdot 2^{e_x}}\right) = \tan^{-1}\left(\frac{m_y}{m_x} \cdot 2^{e_y-e_x}\right) \tag{17}$$

Therefore, in the vectoring mode, an angle exponent $\xi$ is chosen as

$$\xi = e_{y,\text{pre}} - e_{x,\text{pre}} \tag{18}$$

In the rotation mode, the angle exponent $\xi$ is taken from the input angle:

$$\xi = \xi_{\text{in}} \tag{19}$$

The angle exponent is an indication of both the maximum value (range) that a floating-point angle $\alpha$ can attain, and of the absolute precision of the angle. The relative precision is, by definition, more or less constant.

Combining this with the property (14) placed upon the exponents of the rotated data, we have that:

$$\xi_{\text{min}} \leq \xi \leq 0 \tag{20}$$

where $\xi_{\text{min}} = -(2^{N_e}-1)$ is the smallest value that the angle exponent can attain in equation (18).

In the second step (core-rotation), the angle exponent $\xi$ is computed according to formulas (18) and (19), the angle exponent selects the proper base tangent sequence $A_\xi = (a_{0,\xi}, a_{1,\xi},..., a_{n\xi-1,\xi})$ from a set of base tangent sequences $\{A_0, A_{-1},..., A_{\xi\text{min}}\}$.

Each of these base tangent sequences is specifically designed to operate on angles with given domain of convergence and accuracy as determined by the region of the floating-point (x, y)-domain. Each $A_\xi$ also defines

1. a base angle sequence $\{\alpha_i\}_\xi$, consisting of the $n_\xi$ angles $\alpha_{0,\xi}, \alpha_{1,\xi},..., \alpha_{n\xi-1,\xi}$,
2. a domain of convergence $r_\xi$, computed from the base angles in correspondence with formula (7),
3. a scaling factor $K_\xi$, according to formula (3),
4. an accuracy determined by the minimum angle $\alpha_{\text{min},\xi} = \alpha_{n,\xi-1,\xi}$.

The accuracy condition on the minimum base angle $\alpha_{\text{min},\xi}$ and the feasibility condition on domain of convergence $r_\xi$ are:

$$\alpha_{\text{min},\xi} = \tan^{-1}(2^{\xi-N_m-1}) \tag{21}$$

where $N_m$ is the number of bits of the mantissa $m_x$ as defined above and

$$r_\xi \geq \tan^{-1}(2^\xi) \tag{22}$$

This base tangent sequence $A_\xi$ is used to perform micro-rotations, where the general recursion (1) is replaced by

$$x_{i+1} = x_i - \sigma_i a_{i,\xi} y_i$$
$$y_{i+1} = y_i + \sigma_i a_{i,\xi} x_i \tag{23}$$

with the input and output to the recursion being:

$$x_0 = K_\xi^{-1} \, x_{pre} \qquad \text{and} \qquad x_{core} = x_{n\xi}$$
$$y_0 = K_\xi^{-1} \, y_{pre} \qquad \qquad y_{core} = y_{n\xi} \qquad\qquad (24)$$

In the vectoring mode, the $\sigma_i$ are chosen according to

$$\sigma_i = \begin{cases} +1 \text{ if } y_i < 0 \\ -1 \text{ if } y_i \geq 0 \end{cases} \qquad\qquad (25)$$

In the rotation mode, the $\sigma_i$ are determined by the input angle:

$$\sigma_i = \sigma_{i,in} \qquad (26)$$

In both cases, $\sigma_{i,out} = \sigma_i$.

The angle $\gamma$ is represented by a tuple $(\xi, \zeta)$, where $\zeta$ is the angle mantissa which is represented by the sequence of $\sigma$-bits. $\{\sigma_0, \sigma_1,..., \sigma_{n\xi-1}\}$

In the third step (post-rotation), the angle $\beta_{post}$ is computed in the rotation handler 3, according to

$$\beta = \begin{cases} \beta_{pre} \text{ if mode = vectoring} \\ \beta_{in} \text{ if mode = rotating} \end{cases}$$
$$\qquad\qquad (27)$$
$$\beta_{post} = \beta - \beta_{pre}$$
$$\beta_{out} = \beta$$

The input data, $(x,y)_{core}$, is rotated over the angle $\beta_{post}$. The result of the post-rotation is the output vector $(x,y)_{out}$. The post-rotation follows the basic scheme of the pre-rotation. The rotation over $\pi/2$ radians is performed if $\sigma_{\pi/2,post} = 1$, otherwise no rotation is performed. The result of this rotation is an intermediate vector $(x,y)_{temp}$.

```
if σπ/2,post = 1 then
```
$$\begin{cases} x_{temp} = -y_{core} \\ y_{temp} = x_{core} \end{cases}$$
```
else                                            (28)
```
$$\begin{cases} x_{temp} = x_{core} \\ y_{temp} = y_{core} \end{cases}$$
```
end if
```

EP 0 632 369 A1

The rotation of $\pi$ radians is performed if $\sigma_{\pi,post} = 1$, otherwise no rotation is performed.

$$
\begin{aligned}
&\text{if } \sigma_{\pi,post} = 1 \text{ then} \\
&\qquad \left\{ \begin{aligned} x_{out} &= -x_{temp} \\ y_{out} &= -y_{temp} \end{aligned} \right. \\
&\text{else} \qquad\qquad\qquad\qquad (29) \\
&\qquad \left\{ \begin{aligned} x_{out} &= x_{temp} \\ y_{out} &= y_{temp} \end{aligned} \right.
\end{aligned}
$$

The floating-point angle $\alpha$ is represented by the tuple $(\beta,\gamma)$. The value of alpha is given by the sum of the two elements:

$$\alpha = \beta + \gamma \qquad (30)$$

The angle $\beta$ is an integer multiple of $\pi/2$, and is, in itself, represented as a tuple $(\sigma_\pi, \sigma_{\pi/2})$. The value of $\beta$ is given by:

$$\beta = \sigma_\pi \cdot \pi + \sigma_{\pi/2} \cdot \frac{\pi}{2} \qquad (31)$$

where $\sigma_\pi, \sigma_{\pi/2} \in \{0,1\}$.

The angle $\gamma$, with $|\gamma| \leq \pi/4$, is represented by a tuple $(\xi,\zeta)$, where $\xi$ is the angle exponent and $\zeta$ is the angle mantissa represented by the sequence $(\sigma_0, \sigma_1,..., \sigma_{n_\xi-1})$; the value of $\gamma$ is given by

$$\gamma = \sum_{i=0}^{n_\xi-1} \sigma_i \alpha_{i,\xi} \qquad (32)$$

Within the arrangement according to figure 2 there are basically two approaches to implement the desired CORDIC. The first approach relates to an algorithm coupled to a sequential architecture, whereas the second approach relates to an algorithm coupled to a parallel, pipelined architecture.

The difference between the two approaches is how the rotation over the floating-point angle $\gamma$ is implemented. This in turn has effect on how the base tangent sequences $A_\xi$ are chosen.

For the sequential floating-point CORDIC, where the micro-rotations and scaling iterations are performed sequentially, we take the least attainable number of operations per $A_\xi$, and thus achieve a minimum latency in number of clock cycles. This gives rise to a set of base tangent sequences, as shown in table 1 for an example sequential floating-point CORDIC with $N_m = 12$.

For the parallel floating-point CORDIC, where each micro-rotation is assigned to and implemented in a micro-rotation stage, we take the least complexity per micro-rotation, and thus achieve a high throughput and minimal area. The $A_\xi$ are then as shown in table 2 for an example parallel floating-point CORDIC with $N_m = 12$.

The sequential floating-point CORDIC which we explain first follows the main scheme as shown in figure 2 of which the core 2 is now described in detail with reference to figure 3.

Figure 3 shows a preferred embodiment of the core 2 in a sequential floating-point CORDIC arrangement. The core 3 consists of three parts:

(a) an exponent handler 21 receiving the exponents $e_{x,pre}$, $e_{y,pre}$ of the vector $x_{pre}$, $y_{pre}$ and computing a CORDIC table selector $\Xi$, and alignment factors $a_{y,pre}$, $a_{x,core}$ and $a_{y,core}$, exponents $e_{x,core}$, $e_{y,core}$ of the vector $x_{core}$, $y_{core}$ and, depending on the signal mode, either receiving from the operator an angle exponent $\xi_{in}$ or computing an angle exponent $\xi_{out}$;

9

(b) an instruction sequencer 22 receiving the cordic table selector $\Xi$ from the exponent handler 21 and producing a sequence of instructions I;

(c) an instruction execution unit 23 receiving the mantissas $m_{x,pre}$, $m_{y,pre}$ of the vector $x_{pre}$, $y_{pre}$, receiving the alignment factors $a_{y,pre}$, $a_{x,core}$ and $a_{y,core}$ from the exponent handler 21 and receiving the sequence of instructions I supplied by the instruction sequencer 22 and, depending on the signal mode, either receiving an angle mantissa $\zeta_{in}$ supplied by the operator or computing an angle mantissa $\zeta_{out}$ producing mantissas $m_{x,core}$, $m_{y,core}$ of the vector $x_{core}$, $y_{core}$.

The core rotation over the angle $\gamma$ in the sequential floating-point CORDIC consists of three steps. They are:

1. computing exponents ($e_{x,core}$, $e_{y,core}$), an angle exponent $\xi$, a CORDIC table selector $\Xi$, and alignment factors $a_{y,pre}$, $a_{x,core}$, $a_{y,core}$
2. selection of a sequence of instructions I determined by the CORDIC table selector $\Xi$, to perform
   i. loading of initial values
   ii. mantissa alignment
   iii. scaling of the mantissas
   iv. performing micro-rotations
3. execution of the sequence of instructions I to carry out a rotation or vectoring operation on the vector ($x_{pre}$, $y_{pre}$) over the angle $\gamma$ to give the vector ($x_{core}$, $y_{core}$).

We are placing the (implementation) constraint here that all calculations in the core are done in block floating-point. This means that exponent is fixed throughout the calculation and the mantissa is not re-normalized between consecutive additions. This is to prevent the use of expensive floating-point additions for the micro-rotations.

We do take precautions against the possible overflow of the y-mantissa datapath. We align the mantissa and change its exponent accordingly. To guarantee that the overflow is no more than two bits we take:

$$e_{y,core} - e_{x,core} \geq \xi \qquad (33)$$

Due to the pre-rotation, $e_{y,pre} \leq e_{x,pre}$, and so only the y-mantissa ever needs to be aligned.

We force the scaling factor $K_\xi$ to be such that the multiplication with the inverse $K_\xi^{-1}$ in the prescaling of formula (24) is cheap in hardware. For a base tangent sequence $A_\xi$, with domain of convergence satisfying condition (22), the scaling factor is given by

$$K_\xi \approx (1-2^{2\xi-1})^{-1} \qquad (34)$$

The scaling factor of (34) is optimal in the sense of combining an easy multiplication of the inverse scaling factor and a minimal number of micro-rotations. The multiplication with the inverse scaling factor then degenerates to a shift and subtract operation, similar to a CORDIC micro-rotation.

The scaling factor quickly approaches 1 as the angle exponent $\xi$ gets smaller. Hence, after a certain limit, we revert to a generic base tangent sequence $A_\xi$ which has a scaling factor of $K_\xi = 1$ to the required precision and defined by

$$a_{i,\xi} = 2^{\xi-i}, \quad i\in\{0,1,...,N_m+1\} \qquad (35)$$

This base tangent sequence has the required domain of convergence $r_\xi$ as set in equation (22).

The limiting value L of $\xi$ at which the scaling factor $K_\xi$ becomes 1 to enough precision is given by

$$L = \left\lfloor \frac{-N_m - 1}{2} \right\rfloor \qquad (36)$$

In practice this means that for, say, a 12-bit floating-point CORDIC with L = -7, the 7 base tangent sequences $A_0,...,A_{-6}$ must be implemented.

The accuracy for the core datapath of the Floating-point CORDIC follows general guidelines known to the person skilled in the art. The datapath is extended with guard bits on the left (msb) to prevent overflow and extra bits on the right (lsb) to defy the effect of accumulative round-off errors in the micro-rotations. Simulations have proven these measures to be effective.

The base tangent sequences $A_\xi$ for a 12-bit floating-point CORDIC are presented in table 1.

Similar tables may be calculated for a 24-bit mantissa, as required by the IEEE 754 std for single precision floating-point numbers.

In step 1 the angle exponent $\xi$ is computed according to formulas (18) en (19); the exponents are computed as follows (taking the overflow condition (33) into account)

$$e_{x,core} = e_{x,pre}$$
$$e_{y,core} = \max (e_{y,pre}, e_{x,pre} + \xi) \qquad (37)$$

The alignment factors are computed as

$$a_{y,pre} = (e_{y,pre} - e_{y,core})$$
$$a_{x,core} = (e_{y,core} - e_{x,core})$$
$$a_{y,core} = (e_{x,core} - e_{y,core}) \qquad (38)$$

The table selector is taken as

$$\Xi = \max (\xi,L) \qquad (39)$$

In step 2, the instructing sequence $I_\Xi$ is selected according to formula (39) and delivered to the execution unit 22 to perform the rotation as determined by the base tangent sequence $A_\xi$.

In step 3, initial value loading, mantissa alignment and scaling are performed according to

$$m_x[0] = K_\xi^{-1}.m_{x,pre}$$
$$m_y[0] = K_\xi^{-1}.m_{y,pre}.2^{ay,pre} \qquad (40)$$

The micro-rotations are performed sequentially according to the recursion

$$m_x[i+1] = m_x[i] - \sigma_i.a_{i\xi}.2^{ax,core}.m_y[i]$$
$$m_y[i+1] = m_y[i] + \sigma_i.a_{i\xi}.2^{ay,core}.m_x[i] \qquad (41)$$

In the vectoring mode, the $\sigma_i$ are determined from

$$\sigma_i = \begin{cases} 1 & \text{if } m_y[i] < 0 \\ -1 & \text{if } m_y[i] \geq 0 \end{cases} \qquad (42)$$

In the rotation mode, the $\sigma_i$ are determined from the input angle:

$$\sigma_i = \sigma_{i,in} \qquad (43)$$

The values of the mantissas $(m_{x,core}, m_{y,core})$ are given by:

$$m_{x,core} = m_x[n_\xi]$$
$$m_{y,core} = m_y[n_\xi] \qquad (44)$$

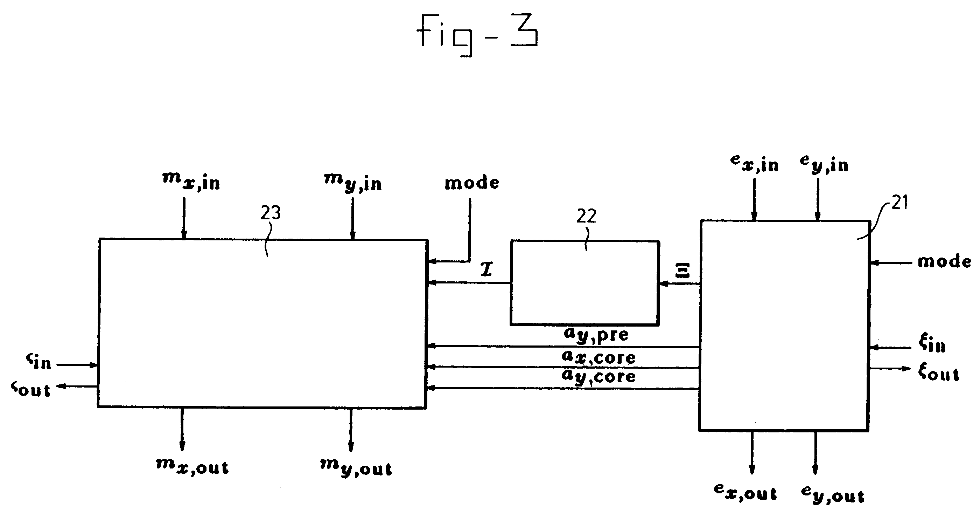

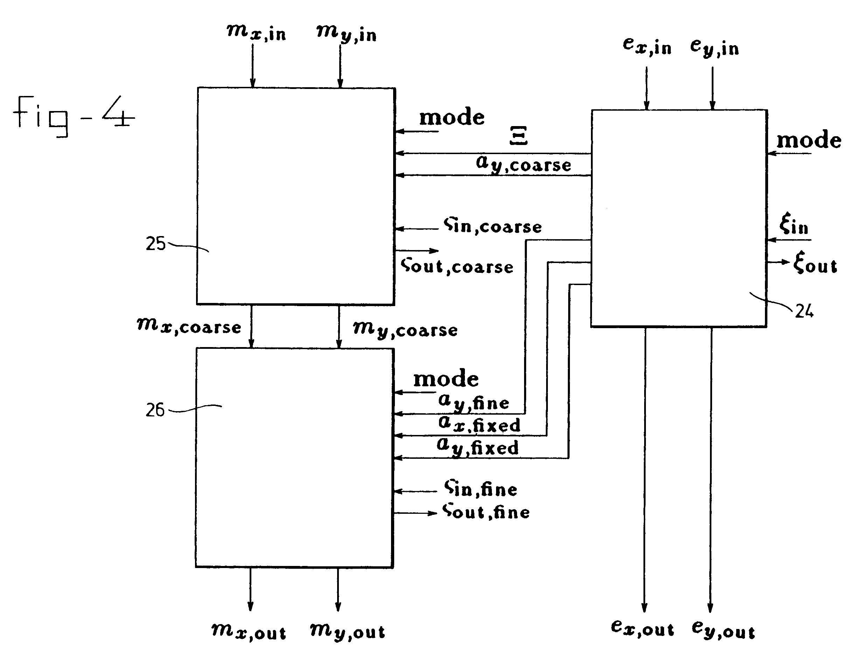

Having described a sequential floating-point CORDIC, now a parallel/pipelined floating-point CORDIC will be described. It follows the main scheme as shown in figure 2 of which the core 2 is now described in detail with reference to figure 4.

Figure 4 shows a design of a core 2 to be used in such a parallel architecture. In figure 4 the core 2 comprises:

(a) an exponent handler 24 receiving the exponents $e_{x,pre}$, $e_{y,pre}$ of the vector $x_{pre}$, $y_{pre}$ and computing a CORDIC table selector $\Xi$, alignment factors $a_{y,coarse}$, $a_{y,fine}$, $a_{y,fixed}$, $a_{y,fixed}$, exponents $e_{x,coarse}$, $e_{y,coarse}$ of a vector $x_{coarse}$, $y_{coarse}$ and, depending on the signal mode, either receiving from the operator an angle exponent $\xi_{in}$ or computing an angle exponent $\xi_{out}$;

(b) a coarse core 25 receiving the mantissas $m_{x,pre}$, $m_{y,pre}$ of the vector $x_{pre}$, $y_{pre}$ and receiving the alignment factor $a_{y,coarse}$ from the exponent handler 24 and, depending on the signal mode, receiving a coarse angle mantissa $\zeta_{in,coarse}$ supplied by the operator, or producing $\zeta_{out,coarse}$, to compute mantissas $m_{x,coarse}$, $m_{y,coarse}$ of the vector $x_{coarse}$, $y_{coarse}$;

(c) a fine core 26 receiving the mantissas $m_{x,coarse}$, $m_{y,coarse}$ from the coarse core 25 and receiving the alignment factors $a_{y,fine}$, $a_{y,fixed}$ and $a_{y,fixed}$ from the exponent handler 24 and, depending upon the signal mode, receiving a fine angle mantissa $\zeta_{in,fine}$ supplied by the operator, or producing $\zeta_{out,fine}$, to compute the mantissas $m_{x,core}$, $m_{y,core}$ of the vector $x_{core}$, $y_{core}$;

wherein the angle mantissa $\zeta$ is represented by a tuple $\zeta_{coarse}$, $\zeta_{fine}$ and, depending on the signal mode, is either input by the operator as $\zeta_{in}$ or computed and output as $\zeta_{out}$.

The core-rotation over the angle $\gamma$ in the parallel floating-point CORDIC consists of three steps. They are:

1. computing exponents ($e_{x,core}$, $e_{y,core}$), an angle exponent $\xi$, a CORDIC table selector $\Xi$, and alignment factors $a_{y,coarse}$, $a_{y,fine}$, $a_{x,fixed}$, $a_{y,fixed}$,

2. carrying out alignment and scaling of the mantissas and carrying out coarse micro-rotations,

3. carrying out further alignment of the mantissas and carrying out fine micro-rotations.

The floating-point angle $\gamma$ is said to be "coarse" if its angle exponent $\xi$ satisfies $0 \leq \xi < L$. Likewise, it is said to be "fine" if $L \leq \xi < \xi_{min}$. The limit L between fine and coarse is given by

$$L = \left\lfloor \frac{-N_m - 2}{2} \right\rfloor \qquad (45)$$

The CORDIC table selector $\Xi$ selects the related base tangent sequence, coarse and fine respectively, as shown in table 2 for a 12-bit parallel floating-point CORDIC. $\Xi$ is given by

$$\Xi = \begin{cases} \text{coarse if } \xi > L \\ \text{fine} \quad \text{if } \xi \leq L \end{cases} \qquad (46)$$

The micro-rotations, both coarse and fine, take place in block floating-point datapaths that compute on mantissas only, and are devoid of floating-point adders. These datapaths can have different exponents, and thus mantissas have to be re-aligned when transferred from one datapath to another. We distinguish four block-floating-point datapaths:

- Two for the coarse micro-rotations, the x and y datapath, with (fixed) exponents $e_{x,coarse}$ and $e_{y,coarse}$. When rotating over a coarse angle with $\xi > L$, these exponents must be equal to each other. Otherwise, for fine angles, the exponent is taken equal to that of the fine y-datapath that follows it.

$e_{y,coarse} = e_{x,coarse}$ if $\xi > L$
$e_{y,coarse} = e_{y,fine}$ if $\xi \leq L$     (47)

and

$e_{x,coarse} = e_{x,pre}$     (48)

- Two for the fine micro-rotations, the x and y datapath, with (fixed) exponents $e_{x,fine}$ and $e_{y,fine}$. The exponent for the y fine datapath must be chosen such that no overflow occurs during computation and still achieve maximum relative precision. This is guaranteed if

$e_{y,fine} = \max(e_{x,coarse} + \xi, e_{y,coarse})$     (49)

and

$$e_{x,fine} = e_{x,coarse} \qquad (50)$$

The coarse base tangent sequence is characterized by:

1. an angular basis $\{\alpha_i\}$, consisting of $n+m$ base angles numbered $\alpha_0, ..., \alpha_{n+m-1}$, where $m = N_m + 2$,
2. a corresponding set of base tangents $\{a_i\}$, such that $a_i = \tan\alpha_i$,
3. a scaling factor $K_{coarse}$, with

$$K_{coarse} = \prod_{i=0}^{n+m-1} (1+a_i^2)^{1/2} \qquad (51)$$

The scaling factor $K_{coarse}$ is chosen, along with the $a_i$, such that the multiplication with $K_{coarse}^{-1}$ is cheap to implement in hardware.

4. an angle domain of convergence, $r_{coarse}$, given by

$$r_{coarse} = \sum_{i=0}^{n+m-1} \alpha_i + \alpha_{min} \qquad (52)$$

and satisfying $r_{coarse} \geq \pi/4$.

5. an angle resolution $\alpha_{min}$ as determined by the minimum angle $\alpha_{min,coarse} = \alpha_{n+m-1}$.
6. a sufficient datapath width, such that the relative precision is not affected for $|\gamma| > r_{fine}$, where $r_{fine}$ is the domain of convergence of the "fine" CORDIC.

The coarse base tangent sequence is implemented partially by the coarse micro-rotations for $i = 0,1,...,n-1$, and partially by the fine micro-rotations for $i = n, n+1,..., n+m-1$.

The "fine" base tangent sequence is characterised by:

1. a maximum angle domain of convergence $r_{fine}$
2. an angle resolution $\alpha_{min}$ that varies with the angle exponent, such that the relative precision of the angle is constant and that the precision in the input vector (from which the angle is computed by vectoring) is preserved.
3. $K_{fine} = 1$ to enough precision.
4. a sufficient datapath width, such that the precision of the mantissas is not affected by roundoff errors, and also such that no overflow occurs in computations. The fine base tangent sequence relies on a linearization of the rotation.
5. the base tangents $a_{i,\xi}$ being given by

$$a_{i,\xi} = 2^{\xi-i}, i \in \{0,1,...,N_m+1\} \qquad (53)$$

The fine base tangent sequence is implemented by the fine micro-rotations $i = n, n+1,..., n+m-1$.

In step 1, the angle exponent $\xi$ is computed according to formulas (18) and (19); the exponents are computed according to formulas (47) - (50); the table selector $\Xi$ is computed according to formula (46); the alignment factors are computed from the differences in the exponents of the individual datapaths, and given by

$$\left\{ \begin{array}{l} a_{y,fine} = e_{y,coarse} - e_{y,fine} \\[1em] a_{x,fixed} = e_{x,coarse} - e_{y,fine} + h \\[1em] a_{y,fixed} = e_{y,coarse} - e_{x,fine} + h \\[1em] a_{y,coarse} = e_{y,pre} - e_{y,coarse} \end{array} \right. \qquad (54)$$

with

$$h = \begin{cases} L & \text{if } L < \xi \\ \xi & \text{if } L \geq \xi \end{cases} \tag{55}$$
$$= \min(L, \xi)$$

In step 2 the "coarse" micro-rotations are performed in the coarse core 26, which rotate vectors over an angle $\gamma_{coarse}$, with enough precision, such that the residue $\gamma_{fine} = \gamma - \gamma_{coarse}$ satisfies $|\gamma_{fine}| \leq r_{fine}$, where $r_{fine}$ is the domain of convergence for the "fine" microrotations. The domain of convergence of the coarse microrotations $r_{coarse}$ satisfies $r_{coarse} \geq \pi/4$ to assure proper continuation from the pre-rotation.

In the case that the angle exponent $\xi \leq L$, the micro-rotations are skipped, the y-mantissa is aligned to the datapath of the fine micro-rotations that follow; the recursion for the micro-rotations is given by:

$$m_{x,coarse}[i+1] = m_{x,coarse}[i]$$
$$m_{y,coarse}[i+1] = m_{y,coarse}[i] \tag{56}$$

for $i = 0 \ldots n-1$ with initialisation

$$m_{x,coarse}[0] = m_{x,pre}$$
$$m_{y,coarse}[0] = m_{y,pre} \cdot 2^{a_{y,coarse}} \tag{57}$$

Otherwise, for $L < \xi$ the recursion for the coarse microrotations is given by:

$$m_{x,coarse}[i+1] = m_{x,coarse}[i] - \sigma_i \cdot a_1 \cdot m_{y,coarse}[i]$$
$$m_{y,coarse}[i+1] = m_{y,coarse}[i] + \sigma_i \cdot a_1 \cdot m_{x,coarse}[i] \tag{58}$$

for $i = 0 \ldots n-1$ with initialisation

$$m_{x,coarse}[0] = K^{-1}_{coarse} \cdot m_{x,pre}$$
$$m_{y,coarse}[0] = K^{-1}_{coarse} \cdot m_{y,pre} \cdot 2^{a_{y,coarse}} \tag{59}$$

In the vectoring mode, the $\sigma_i$, are determined from

$$\sigma_i = \begin{cases} 1 & \text{if } m_{y,coarse}[i] < 0 \\ -1 & \text{if } m_{y,coarse}[i] \geq 0 \end{cases} \tag{60}$$

In the rotation mode, the $\sigma_i$, are determined from the input angle:

$$\sigma_i = \sigma_{i,in} \tag{61}$$

and the resulting mantissas are given by:

$$m_{x,coarse} = m_{x,coarse}[n]$$
$$m_{y,coarse} = m_{y,coarse}[n] \tag{62}$$

In step 3 the "fine" micro-rotations are performed in the fine core 27. These rotate vectors over the

remaining $\gamma_{fine}$, with $|\gamma_{fine}| \leq r_{fine}$, utilising a linearization of the angle.

The recursion for the fine micro-rotations is given by:

$$m_{x,fine}[i+1] = m_{x,fine}[i] - \sigma_i . 2^{-i} . m_{y,fixed}$$
$$m_{y,fine}[i+1] = m_{y,fine}[i] + \sigma_i . 2^{-i} . m_{x,fixed} \qquad (63)$$

for $i = n,...,n+m-1$ with initialisation

$$\begin{aligned}
m_{x,fine}[n] &= m_{x,coarse} \\
m_{y,fine}[n] &= m_{y,coarse} . 2^{a_{y,fine}} \\
m_{x,fixed} &= m_{x,coarse} . 2^{a_{x,fixed}} \\
m_{y,fixed} &= m_{y,coarse} . 2^{a_{y,fixed}}
\end{aligned} \qquad (64)$$

Like for the coarse micro-rotations, the $\sigma_i$ are determined in the vectoring mode from

$$\sigma_i = \begin{cases} 1 & \text{if } m_{y,fine}[i] < 0 \\ -1 & \text{if } m_{y,fine}[i] \geq 0 \end{cases} \qquad (65)$$

In the rotation mode, the $\sigma_i$ are determined from the input angle:

$$\sigma_i = \sigma_{i,in} \qquad (66)$$

The output vector $(x_{core}, y_{core})$ is given by

$$\begin{aligned}
m_{x,core} &= m_{x,fine}[n+m] \\
m_{y,core} &= m_{y,fine}[n+m] \\
e_{x,core} &= e_{x,fine} \\
e_{y,core} &= e_{y,fine} \qquad (67)
\end{aligned}$$

| Base tangent sequence | $\mathcal{A}_0$ | $\mathcal{A}_{-1}$ | $\mathcal{A}_{-2}$ | $\mathcal{A}_{-3}$ | $\mathcal{A}_{-4}$ | $\mathcal{A}_{-5}$ | $\mathcal{A}_{-6}$ | $\mathcal{A}_\xi$ |
|---|---|---|---|---|---|---|---|---|
| $\xi$ | 0 | $-1$ | $-2$ | $-3$ | $-4$ | $-5$ | $-6$ | $\leq -7$ |
| $\Xi$ | 0 | $-1$ | $-2$ | $-3$ | $-4$ | $-5$ | $-6$ | $-7$ |
| $K_\xi$ | 2 | $\frac{8}{7}$ | $\frac{32}{31}$ | $\frac{128}{127}$ | $\frac{512}{511}$ | $\frac{2048}{2047}$ | $\frac{8192}{8191}$ | 1 |
| $K_\xi^{-1}$ | $1-2^{-1}$ | $1-2^{-3}$ | $1-2^{-5}$ | $1-2^{-7}$ | $1-2^{-9}$ | $1-2^{-11}$ | $1-2^{-13}$ | 1 |
| Cordic iteration | $a_{i,\xi}$ | | | | | | | $a_{i,\xi}$ |
| 1 | $2^{-0}+2^{-4}$ | $2^{-1}$ | $2^{-3}+2^{-4}$ | $2^{-4}+2^{-5}$ | $2^{-5}+2^{-7}$ | $2^{-6}$ | $2^{-6}$ | $2^{\xi-0}$ |
| 2 | $2^{-1}+2^{-3}$ | $2^{-3}$ | $2^{-3}+2^{-7}$ | $2^{-4}$ | $2^{-5}$ | $2^{-6}$ | $2^{-7}$ | $2^{\xi-1}$ |
| 3 | $2^{-1}$ | $2^{-3}$ | $2^{-4}+2^{-6}$ | $2^{-5}+2^{-7}$ | $2^{-5}$ | $2^{-6}$ | $2^{-8}$ | $2^{\xi-2}$ |
| 4 | $2^{-2}-2^{-7}$ | $2^{-4}$ | $2^{-4}$ | $2^{-5}$ | $2^{-6}$ | $2^{-7}$ | $2^{-9}$ | $2^{\xi-3}$ |
| 5 | $2^{-3}$ | $2^{-4}$ | $2^{-5}$ | $2^{-6}$ | $2^{-7}$ | $2^{-8}$ | $2^{-10}$ | $2^{\xi-4}$ |
| 6 | $2^{-4}$ | $2^{-4}$ | $2^{-6}$ | $2^{-7}$ | $2^{-8}$ | $2^{-9}$ | $2^{-11}$ | $2^{\xi-5}$ |
| 7 | $2^{-5}$ | $2^{-5}$ | $2^{-7}$ | $2^{-8}$ | $2^{-9}$ | $2^{-10}$ | $2^{-12}$ | $2^{\xi-6}$ |
| 8 | $2^{-6}$ | $2^{-6}$ | $2^{-8}$ | $2^{-9}$ | $2^{-10}$ | $2^{-11}$ | $2^{-13}$ | $2^{\xi-7}$ |
| 9 | $2^{-7}$ | $2^{-7}$ | $2^{-9}$ | $2^{-10}$ | $2^{-11}$ | $2^{-12}$ | $2^{-14}$ | $2^{\xi-8}$ |
| 10 | $2^{-8}$ | $2^{-8}$ | $2^{-10}$ | $2^{-11}$ | $2^{-12}$ | $2^{-13}$ | $2^{-15}$ | $2^{\xi-9}$ |
| 11 | $2^{-9}$ | $2^{-9}$ | $2^{-11}$ | $2^{-12}$ | $2^{-13}$ | $2^{-14}$ | $2^{-16}$ | $2^{\xi-10}$ |
| 12 | $2^{-10}$ | $2^{-10}$ | $2^{-12}$ | $2^{-13}$ | $2^{-14}$ | $2^{-15}$ | $2^{-17}$ | $2^{\xi-11}$ |
| 13 | $2^{-11}$ | $2^{-11}$ | $2^{-13}$ | $2^{-14}$ | $2^{-15}$ | $2^{-16}$ | $2^{-18}$ | $2^{\xi-12}$ |
| 14 | $2^{-12}$ | $2^{-12}$ | $2^{-14}$ | $2^{-15}$ | $2^{-16}$ | $2^{-17}$ | $2^{-19}$ | $2^{\xi-13}$ |
| 15 | $2^{-13}$ | $2^{-13}$ | $2^{-15}$ | $2^{-16}$ | $2^{-17}$ | $2^{-18}$ | — | — |
| 16 | — | $2^{-14}$ | — | — | — | — | — | — |

Table 1: The set of base tangent sequences $\mathcal{A}_\xi$ for the sequential floating-point Cordic

| Base tangent sequence | $\mathcal{A}_0 \ldots \mathcal{A}_{-6}$ | $\mathcal{A}_\xi$ |
|---|---|---|
| $\xi$ | $0 \ldots -6$ | $\leq -7$ |
| $\Xi$ | coarse | fine |
| $K_\xi$ | $2$ | $1$ |
| $K_\xi^{-1}$ | $2^{-1}$ | $1$ |
| coarse micro-rotations | $a_{i,\xi}$ | $a_{i,\xi}$ |
| 1 | $2^{-0} + 2^{-4}$ | — |
| 2 | $2^{-1} + 2^{-3}$ | — |
| 3 | $2^{-1}$ | — |
| 4 | $2^{-2} - 2^{-7}$ | — |
| 5 | $2^{-3}$ | — |
| 6 | $2^{-4}$ | — |
| 7 | $2^{-5}$ | — |
| 8 | $2^{-6}$ | — |
| fine micro-rotations | $a_{i,\xi}$ | $a_{i,\xi}$ |
| 9 | $2^{-7}$ | $2^{\xi}$ |
| 10 | $2^{-8}$ | $2^{\xi-1}$ |
| 11 | $2^{-9}$ | $2^{\xi-2}$ |
| 12 | $2^{-10}$ | $2^{\xi-3}$ |
| 13 | $2^{-11}$ | $2^{\xi-4}$ |
| 14 | $2^{-12}$ | $2^{\xi-5}$ |
| 15 | $2^{-13}$ | $2^{\xi-6}$ |
| 16 | $2^{-14}$ | $2^{\xi-7}$ |
| 17 | $2^{-15}$ | $2^{\xi-8}$ |
| 18 | $2^{-16}$ | $2^{\xi-9}$ |
| 19 | $2^{-17}$ | $2^{\xi-10}$ |
| 20 | $2^{-18}$ | $2^{\xi-11}$ |
| 21 | $2^{-19}$ | $2^{\xi-12}$ |
| 22 | $2^{-20}$ | $2^{\xi-13}$ |

Table 2: The set of base tangent sequences $\mathcal{A}_\xi$ for the parallel floating-point Cordic

**Claims**

1. A CORDIC arrangement to rotate an input vector $(x_{in}, y_{in})$ over an angle $\alpha$ to an output vector $(x_{out}, y_{out})$, characterized in that $x_{in}$, $y_{in}$, $x_{out}$, $y_{out}$ are represented by floating-point numbers with respective mantissas $(m_x, m_y)$ and respective angle exponents $(e_x, e_y)$ and the CORDIC arrangement comprises:

    (a) a pre-rotation unit (1) receiving the input vector $(x_{in}, y_{in})$ to rotate the input vector $(x_{in}, y_{in})$ over an angle $\beta_{pre}$ to give a vector $(x_{pre}, y_{pre})$;

    (b) a core (2) receiving the vector $(x_{pre}, y_{pre})$ from the pre-rotation unit (1) to rotate the vector $(x_{pre}, y_{pre})$ over an angle $\gamma$ to give a vector $(x_{core}, y_{core})$, where the angle $\gamma$, depending on a signal mode supplied by an operator, is either supplied by the operator as $\gamma_{in}$ or computed and output as $\gamma_{out}$;

17

(c) a rotation handler (3) receiving the angle $\beta_{pre}$ from the pre-rotation unit (1) and the signal mode supplied by an operator, and a possible angle $\beta_{in}$ supplied by the operator to compute angles $\beta_{post}$, $\beta_{out}$ in dependence thereon;

(d) a post-rotation unit (4) receiving the vector $(x_{core}, y_{core})$ from the core (2) and receiving the angle $\beta_{post}$ from the rotation handler (3) to rotate the vector $(x_{core}, y_{core})$ over the angle $\beta_{post}$ to give the output vector $(x_{out}, y_{out})$;

wherein

(a) the floating-point angle $\alpha$ is represented by a tuple $(\beta, \gamma)$, $\beta$ being the sum of $\beta_{pre}$ and $\beta_{post}$, and $\gamma$ being represented by a tuple $(\xi, \zeta)$, of which $\xi$ is an angle exponent and $\zeta$ is an angle mantissa;

(b) $\alpha$ equals the sum of $\beta$ and $\gamma$.

2. A CORDIC arrangement according to claim 1 characterized in that the core (2) comprises:

(a) an exponent handler (21) receiving the exponents $(e_{x,pre}, e_{y,pre})$ of the vector $(x_{pre}, y_{pre})$ and computing a CORDIC table selector $\Xi$, and alignment factors $a_{y,pre}$, $a_{x,core}$ and $a_{y,core}$, exponents $(e_{x,core}, e_{y,core})$ of the vector $(x_{core}, y_{core})$ and, depending on the signal mode, either receiving from the operator an angle exponent $\xi_{in}$ or computing an angle exponent $\xi_{out}$;

(b) an instruction sequencer (22) receiving the cordic table selector $\Xi$ from the exponent handler (21) and producing a sequence of instructions I;

(c) an instruction execution unit (23) receiving the mantissas $(m_{x,pre}, m_{y,pre})$ of the vector $(x_{pre}, y_{pre})$, receiving the alignment factors $a_{y,pre}$, $a_{x,core}$ and $a_{y,core}$ from the exponent handler (21) and receiving the sequence of instructions I supplied by the instruction sequencer (22) and, depending on the signal mode, either receiving an angle mantissa $\zeta_{in}$ supplied by the operator or computing an angle mantissa $\zeta_{out}$ producing mantissas $(m_{x,core}, m_{y,core})$ of the vector $(x_{core}, y_{core})$.

3. A CORDIC arrangement according to claim 1 characterized in that the core (2) comprises:

(a) an exponent handler (24) receiving the exponents $(e_{x,pre}, e_{y,pre})$ of the vector $(x_{pre}, y_{pre})$ and computing a CORDIC table selector $\Xi$, alignment factors $a_{y,coarse}$, $a_{y,fine}$, $a_{y,fixed}$, $a_{y,fixed}$, exponents $(e_{x,coarse}, e_{y,coarse})$ of a vector $(x_{coarse}, y_{coarse})$ and, depending on the signal mode, either receiving from the operator an angle exponent $\xi_{in}$ or computing an angle exponent $\xi_{out}$;

(b) a coarse core (25) receiving the mantissas $(m_{x,pre}, m_{y,pre})$ of the vector $(x_{pre}, y_{pre})$ and receiving the alignment factor $a_{y,coarse}$ from the exponent handler (24) and, depending on the signal mode, receiving a coarse angle mantissa $\zeta_{in,coarse}$ supplied by the operator, or producing $\zeta_{out,coarse}$, to compute mantissas $(m_{x,coarse}, m_{y,coarse})$ of the vector $(x_{coarse}, y_{coarse})$;

(c) a fine core (26) receiving the mantissas $(m_{x,coarse}, m_{y,coarse})$ from the coarse core (25) and receiving the alignment factors $a_{y,fine}$, $a_{y,fixed}$ and $a_{y,fixed}$ from the exponent handler (24) and, depending upon the signal mode, receiving a fine angle mantissa $\zeta_{in,fine}$ supplied by the operator, or producing $\zeta_{out,fine}$, to compute the mantissas $(m_{x,core}, m_{y,core})$ of the vector $(x_{core}, y_{core})$;

wherein the angle mantissa $\zeta$ is represented by a tuple $(\zeta_{coarse}, \zeta_{fine})$ and, depending on the signal mode, is either input by the operator as $\zeta_{in}$ or computed and output as $\zeta_{out}$.

4. A CORDIC method to rotate an input vector $(x_{in}, y_{in})$ received from an input means over an angle $\alpha$ to an output vector $(x_{out}, y_{out})$ to be supplied to an output means, characterized in that $x_{in}$, $y_{in}$, $x_{out}$, $y_{out}$ are represented by floating-point numbers with respective mantissas $(m_x, m_y)$ and respective angle exponents $(e_x, e_y)$ comprising:

(a) a pre-rotation of the input vector $(x_{in}, y_{in})$ over an angle $\beta_{pre}$ to give a vector $(x_{pre}, y_{pre})$ in accordance with formulas (12-16);

(b) a core rotation or a vectoring operation by rotating the vector $(x_{pre}, y_{pre})$ over an angle $\gamma$ to give a vector $(x_{core}, y_{core})$, in accordance with formulas (18-26);

(c) calculation of angles $\beta_{post}$ and $\beta_{out}$ in accordance with formula (27);

(d) a post-rotation of the vector $(x_{core}, y_{core})$ over the angle $\beta_{post}$ to give the output vector $(x_{out}, y_{out})$ in accordance with formulas (28, 29).

5. A CORDIC method according to claim 4 characterized in that step 4(b) comprises the steps of

(a) computing exponents $(e_{x,core}, e_{y,core})$, an angle exponent $\xi$, a CORDIC table selector $\Xi$, and alignment factors $a_{y,pre}$, $a_{x,core}$, $a_{y,core}$, in accordance with formulas (18, 19, 37-39);

(b) selection of a sequence of instructions I determined by the CORDIC table selector $\Xi$, to perform

i. loading of initial values

ii. mantissa alignment

iii. scaling of the mantissas

iv. performing micro-rotations

(c) execution of the sequence of instructions I to carry out a rotation or vectoring operation on the vector $(x_{pre}, y_{pre})$ over the angle $\gamma$ to give the vector $(x_{core}, y_{core})$ in accordance with formulas (40-44).

6. A CORDIC method according to claim 4 characterized in that step 4(b) comprises the steps of

(a) computing exponents $(e_{x,core}, e_{y,core})$, an angle exponent $\xi$, a CORDIC table selector $\Xi$, and alignment factors $a_{y,coarse}, a_{y,fine}, a_{x,fixed}, a_{y,fixed}$, in accordance with formulas (18, 19, 46-50, 54, 55);

(b) carrying out alignment and scaling of the mantissas in accordance with formulas (57, 59);

(c) carrying out coarse micro-rotations in accordance with formulas (56-62);

(d) carrying out further alignment of the mantissas in accordance with formula (64);

(e) carrying out fine micro-rotations in accordance with formulas (63-67).

# fig - 1

# Fig-2

$x_{in}$   $y_{in}$

1

$\beta_{pre}$   mode

$x_{pre}$   $y_{pre}$

3

mode

$\beta_{in}$

$\beta_{out}$

$\gamma_{in}$
$\gamma_{out}$

2

$\beta_{post}$

$x_{core}$   $y_{core}$

4

$x_{out}$   $y_{out}$

# Fig-3

EP 0 632 369 A1

Fig-4

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| A | PROCEEDINGS OF VLSI AND COMPUTERS. FIRST INTERNATIONAL CONFERENCE ON COMPUTER TECHNOLOGY, SYSTEMS AND APPLICATIONS. COMPEURO 87, HAMBURG, WEST GERMANY, 11-15 MAY 1987. 1987 , IEEE COMPUTER SOCIETY PRESS, WASHINGTON, DC, USA. pages 727 - 730 B. YANG, ET AL. 'Special computers: graphics, robotics' * figures 2,3 * | 1,3,4,6 | G06F7/544 |
| A | PROCEEDINGS OF THE 10TH IEEE SYMPOSIUM ON COMPUTER ARITHMETIC, GRENOBLE, FRANCE, 26-28 JUNE  1991. 1991 , IEEE COMPUTER SOCIETY PRESS, LOS ALAMITOS, CA., USA. pages 272 - 281 A. DE LANGE ET AL. 'Design and Implementation of a Floating-point Quasi-Systolic General Purpose CORDIC Rotator for High-rate Parallel Data and Signal Processing' * sections 4, 5 ; figure 5.1 * | 1,4 | |
| A | PROCEEDINGS OF THE 1989 IEEE INTERNATIONAL SYMPOSIUM ON CIRCUITS AND SYSTEMS, ISCAS '89, 8-11 MAY 1989, PORTLAND, OR, USA. vol. 1 , 1989 , IEEE COMPUTER SOCIETY PRESS, LOS ALAMITOS, CA., USA. pages 175 - 178 YU HEN HU ET AL. 'ANGLE RECODING METHOD FOR EFFICIENT IMPLEMENTATION OF THE CORDIC ALGORITHM' * page 177, left column, line 10 - line 12 * | 1,4 | TECHNICAL FIELDS SEARCHED (Int.Cl.6)<br><br>G06F |

The present search report has been drawn up for all claims

| Place of search | Date of completion of the search | Examiner |
|---|---|---|
| THE HAGUE | 30 November 1993 | Verhoof, P |

EPO FORM 1503 03.82 (P04C01)